Europäisches Patentamt

European Patent Office

Office européen des brevets

(19)

(11) Numéro de publication: **0 012 657**
**B1**

(12) **FASCICULE DE BREVET EUROPEEN**

(45) Date de publication du fascicule du brevet: **16.03.83**

(21) Numéro de dépôt: **79400940.7**

(22) Date de dépôt: **30.11.79**

(51) Int. Cl.³: **H 03 D 7/14,** H 03 C 1/54, H 04 B 1/28

(54) **Mélangeur en anneau passif à large bande et récepteur comportant un tel mélangeur.**

(30) Priorité: **15.12.78 FR 7835387**

(43) Date de publication de la demande:
**25.06.80 Bulletin 80/13**

(45) Mention de la délivrance du brevet:
**16.03.83 Bulletin 83/11**

(84) Etats contractants désignés:
**DE GB IT NL**

(56) Documents cités:
BE - A - 660 301
DE - A - 2 105 431
DE - B - 1 300 154
FR - A - 1 145 796
FR - A - 1 457 247

ELECTRONIC DESIGN, Vol. 26, no. 6, Mars 1978 Rochelle Park (US) ROHDE: "Improve double-balanced mixer response with an active-circuit design", pp. 140, 142

(73) Titulaire: **THOMSON-CSF**
**173, Boulevard Haussmann**
**F-75379 Paris Cedex 08 (FR)**

(72) Inventeur: **Boubouleix, Albert**
**"THOMSON-CSF" - SCPI 173, bld Haussmann**
**F-75360 Paris Cedex 08 (FR)**

(74) Mandataire: **Blaise, Michel et al,**
**"THOMSON-CSF" - SCPI 173, bld Haussmann**
**F-75379 Paris Cedex 08 (FR)**

(56) Documents cités:
PHILIPS APPLICATION INFORMATION no. 527, 1er novembre 1968, Philips Gloeilampenfabrieken, Eindhoven, NL: "TAB 101 integrated four-transistor modulator", pp. 5—11
NEC RESEARCH AND DEVELOPMENT, no. 32, janvier 1974, Tokyo, JP:OHYAMA et al. "New group translating equipment and supergroup translating equipment", pp. 86—95

Courier Press, Leamington Spa, England.

Mélangeur en anneau passif à large bande et récepteur comportant un tel mélangeur

L'invention concerne les mélangeurs en anneau passif à large bande et en particulier ceux utilisés comme mélangeurs d'entrée dans les récepteurs à ondes métriques ou décrimétriques.

Les modulateurs en anneau à diodes et en particulier ceux comportant un anneau de quatre diodes identiques sont connus pour leurs bonnes caractéristiques aux fréquences élevées, en particulier la basse impédance de leurs circuits, autorisant une large bande passante; mais de bonnes performances en intermodulation et transmodulation sont tributaires d'une puissance d'oscillation locale suffisante.

Aux fréquences élevées, par exemple dans la gamme d'ondes décimétriques, le rendement global d'un oscillateur local est faible, de l'ordre de 10 à 15%, et les récepteurs portables et portatifs voient leur autonomie de fonctionnement fortement pénalisée par la consommation d'énergie correspondant à l'obtention de cette puissance suffisante.

De nombreuses structures de mélangeurs en anneau sont connues utilisant des transistors actifs à la place des diodes afin de bénéficier de leur gain. Les demandes de brevets français 1 457 247 et 1 145 796 ainsi qu'un article du 1er novembre 1968 paru dans Philips Application Information, No. 527, page 6, décrivent de telles structures. Elles autorisent une réduction de la puissance de l'oscillation locale, mais les bonnes conditions de linéarité recherchées ne sont obtenues dans aucune de ces structure à cause des défauts intrinsèques des transistors actifs, en particulier la caractéristique exponentielle du courant de base en fonction de la tension base-émetteur et les variations du coefficient d'amplification en courant en fonction du courant collecteur. Il s'y ajoute également des difficultés d'équilibrage dues à la dispersion des caractéristiques.

Le problème posé est donc la réalisation d'un mélangeur en anneau ayant une autonomie de fonctionnement convenable sans que la linéarité de sa caractéristique ne soit affectée.

Selon l'invention, un mélangeur en anneau comportant:

— un premier transformateur comprenant un enroulement primaire recevant un signal incident, et un secondaire symétrique ayant un point milieu relié à la masse, une première et une seconde extrémité;

— un second transformateur comprenant un secondaire fournissant le signal de sortie du mélangeur, et un primaire symétrique ayant un point milieu relié à la masse, une première et une seconde extrémité;

— un premier et un second dispositif à semi-conducteurs reliant respectivement entre elles les deux premières et les deux secondes extrémités;

— un troisième et un quatrième dispositif semi-conducteurs reliant respectivement la première extrémité du secondaire symétrique avec la seconde extrémité du primaire symétrique et la seconde extrémité du secondaire symétrique avec la première extrémité du primaire symétrique;

— les premier, second, troisième et quatrième dispositifs semi-conducteurs étant respectivement l'espace collecteur-émetteur d'un premier, second, troisième et quatrième transistors de même type, le raccordement de ces quatre transistors étant tel que chaque électrode de même type soit reliée à la première ou seconde extrémité d'un même transformateur;

— un dispositif générateur symétrique d'un signal d'oscillation locale ayant deux sorties; est caractérisé en ce qu'il comporte en outre: un premier circuit de couplage ayant une entrée couplée à l'une des sorties du dispositif générateur, et deux sorties; et un second circuit de couplage ayant une entrée couplée à l'autre des deux sorties du dispositif générateur et deux sorties; les deux sorties du premier circuit de couplage alimentant en phase respectivement les bases des premier et second transistors, les deux sorties du second circuit alimentant en phase respectivement les bases des troisième et quatrième transistors, l'impédance entre chacune des deux sorties de chaque dispositif de couplage étant grande à la fréquence du signal incident par rapport aux impédances de charges dynamiques des premier et second transformateurs et faible à la fréquence d'oscillation locale.

Les avantages obtenus grâce à cette invention sont une linéarité équivalant à celle d'un mélangeur à diodes pour un même niveau de signal incident, mais avec une puissance de signal d'oscillation locale sensiblement réduite, ou une linéarité accrue pour une même puissance de ce dernier signal que dans le cas du mélangeur à diodes.

L'invention sera mieux comprise et d'autres caractéristiques apparaîtront à l'aide de la description ci-après et des dessins s'y rapportant sur lesquels:

— la figure 1 est un schéma général d'un mélangeur en anneau selon l'invention;
— la figure 2 est une variante d'une partie du schéma de la figure 1.

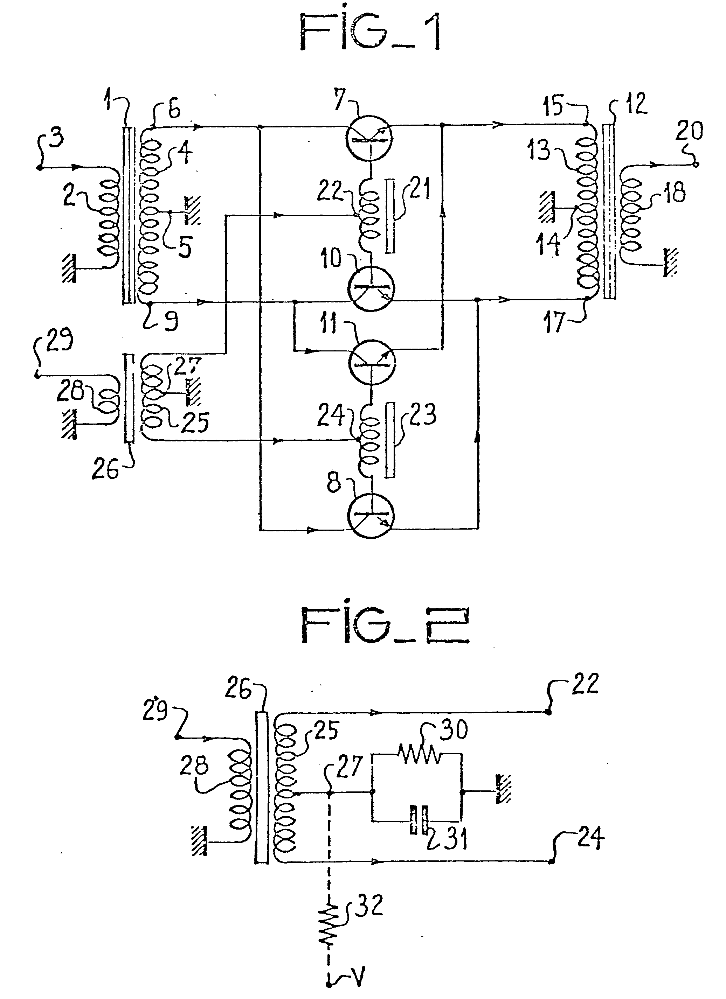

Sur la figure 1, un transformateur 1 comporte un enroulement primaire 2 dont une extrémité est reliée à la masse et l'autre à la borne 3 recevant la signal incident; son secondaire symétrique 5 possède un point milieu 5 relié à la masse, une première extrémité 6 connectée au collecteur de chacun des transistors 7 et 8, et une extrémité 9 connectée au collecteur de chacun des transistors 10 et 11. Un transformateur 12 possède un enroulement primaire symétrique 13 dont le point milieu 14 est relié à la masse et dont une extrémité 15 est connectée à l'émetteur de chacun des transistors 7 et 11, et une autre extrémité 17 est connectée aus émetteurs des transistors 10 et 8; son enroulement secondaire 18 a une extrémité connectée à la masse et l'autre extrémité à une borne de sortie 20. Les bases des transistors 7 et 10 sont connectées respectivement aux deux extrémité d'une self inductance 21 ayant un point milieu 22; de même les bases des transistors 11 et 8 sont reliées respectivement aux deux extrémités d'une self inductance 23 ayant un point milieu 24. Ces points milieux 22 et 24 sont connectées aux extrémité d'un enroulement secondaire 25 d'un transformateur 26, dont le point milieu 27 est connectée à la masse. Ce transformateur 26 possède un primaire 28 dont une extrémité est reliée à la masse et l'autre à une borne d'entrée 29 destinée à recevoir un signal d'oscillation locale.

Ce mélangeur se distingue du mélangeur en anneau connu à quatre diodes, d'une part, par le fait que chaque diode est remplacée par l'espace collecteur-émetteur d'un transistor, d'autre part par le mode d'application de la tension d'oscillation locale à ces transistors, à travers des circuits de couplage passifs (selfs 21 et 23).

Les émetteurs et collecteurs des transistors 7, 10, 11 et 8 de type NPN sont polarisés à la masse, ces transistors sont donc saturés, et leur espace collecteur-émetteur passant, lorsque leur base est positive; inversement ils sont bloqués lorsqu'elle est négative.

Le signal d'oscillation locale appliquée sur la borne 29 parvient en opposition de phase aux points milieux 22 et 24 des selfs respectives 21 et 23 qui sont bobinées avec un fort couplage entre spires et calculées de manière à présenter une impédance élevé au signal incident appliqué à la borne 3, afin d'éviter de modifier la charge de l'enroulement secondaire 4, et, au contraire, une impédance faible à la fréquence de l'oscillation locale appliquée sur leur point milieu.

Dans l'exemple décrit les selfs 21 et 23 ont été réalisées par bobinage sur un tore de ferrite des deux moitiés de la self considérée avec deux fils en main.

Ainsi la paire de transistors 7, 10 est passante et la paire 11, 8 bloquée lorsque la tension d'oscillation locale est respectivement positive au point 22 et négative au point 24, la situation des transistors s'inversant avec la polarité de la tension d'oscillation locale.

Le découpage du signal incident par le signal d'oscillation locale a donc lieu de la même manière que dans le mélangeur à diodes à ce détail très important près que le courant d'oscillation locale ne parcourt plus l'anneau semiconducteur, il alimente les circuits de base des transistors pour commander les courants collecteurs, c'est-à-diré des courants dûs au signal incident, beaucoup plus importants, d'environ 10 fois, que le courant de base.

Dans l'exemple décrit en expérimenté, les transistors étaient du type NE 64535 de la NEC (Nippon Electric Company), avec les conditions d'utilisation suivantes:

Fréquence du signal incident: 400 MHz
Fréquence du signal d'oscillation locale; 480 MHz
Fréquence du signal de sortie: 80 MHz
Puissance appliquée à la fréquence d'oscillation locale: +13 dBm.

Il a été mesuré un niveau d'intermodulation de 16 dB supérieur à celui obtenu avec les mailleurs diodes connues, adaptées à ces fréquences, avec lesquelles les mêmes performances d'intermodulation auraient demandées une puissance d'oscillation locale de quelque 8 dB supérieure.

Lorsqu'il est possible de se contenter de performances d'intermodulation moyenne ou faible, il en résulte l'utilisation de faibles puissances d'oscillation locale, vis-à-vis desquelles le seuil des junctions des transistors est une cause de dimunution de l'efficacité du montage. Il est possible d'y remédier par une variante dans l'alimentation en courant par le signal d'oscillation locale, montrée par la figure suivante.

Sur la figure 2, où les mêmes repères que sur la figure 1 concernent les mêmes organes, le point milieu 27 de l'enroulement 25 est connecté à la masse à travers une résistance 30 découplée par un condensateur 31. En variante, le point 27 peut être relié à une source de tension positive V à travers une résistance 32.

Il est connu que toute jonction semi-conductrice présente une barrière de potentiel qu'il faut franchir pour la rendre conductrice, il est donc nécessaire, pour commencer à rendre conducteur l'espace collecteur-émetteur des transistors 7, 10, 11 ou 8, d'atteindre une tension de base légèrement positive (généralement inférieure à 1V), ceci est obtenu par auto-polarisation sur le courant moyen de base de ces quatre transistors à travers la résistance 30. De cette manière lorsque le niveau d'oscillation locale est faible la symétrie est maintenue entre le temps de blocage et de déblocage des jonctions qui correspondent alors effectivement aux instants des alternances respectivement négatives et positives du signal d'oscillation locale.

Afin d'éviter l'utilisation d'une résistance 30 de valeur élevée, lorsque le niveau d'oscillation locale est particulièrement faible, l'auto-polarisation peut être complétée par le polarisation fixe de la source V.

Bien entendu d'autres modes de réalisation sont possibles sans sortir du cadre de l'invention. En particulier les transistors peuvent être de type PNP au lieu de NPN, ce qui entraîne évidemment l'inversion de la polarité d'une éventuelle source de tension continue V. Les selfs à point milieu 21 et 23 peuvent être remplacées par tout organe de couplage connu assurant une impédance élevée vis-à-vis du signal incident transmis entre les bases des transistors concernés et une impédance faible vis-à-vis du signal d'oscillation locale entre les points 22 ou 24 et les bases de transistors respectivement concernés.

**Revendications**

1. Mélangeur en anneau comportant:

— un premier transformateur (1) comprenant un enroulement primaire (2) recevant un signal incident, et un secondaire symétrique (4) ayant un point milieu (5) relié à la masse, une première et une seconde extrémité (6, 9);

— un second transformateur (12) comprenant un secondaire (18) fournissant le signal de sortie du mélangeur, et un primaire symétrique (13) ayant un point milieu (14) relié à la masse, une première et une seconde extrémité (15, 17);

— un premier et un second dispositif à semiconducteurs (7, 10) reliant respectivement entre elles les deux premières (6, 15) et les deux secondes (9, 17) extrémités;

— un troisième et un quatrième dispositif semiconducteurs (8, 11) reliant respectivement la première extrémité (6) du secondaire symétrique (4) avec la seconde extrémité (17) du primaire symétrique (13) et la seconde extrémité (9) du secondaire symétrique (4) avec la première extrémité (15) du primaire symétrique (13);

— les premier, second, troisième et quatrième dispositifs semi-conducteurs étant respectivement l'espace collecteur-émetteur d'un premier, second, troisième et quatrième transistors de même type, le raccordement de ces quatre transistors étant tel que chaque électrode de même type soit reliée à la première ou seconde extrémité d'un même transformateur;

— un dispositif générateur symétrique (26) d'un signal d'oscillation locale ayant deux sorties; caractérisé en ce qu'il comporte en outre: un premier circuit de couplage (21) ayant une entrée (22) couplée à l'une des sorties du dispositif générateur, et deux sorties; et un second circuit de couplage (23) ayant une entrée (24) couplée à l'autre des deux sorties du dispositif générateur et deux sorties; les deux sorties du premier circuit de couplage (21) alimentant en phase respectivement les bases des premier et second transistors, les deux sorties du second circuit (23) alimentant en phase respectivement les bases des troisième et quatrième transistors, l'impédance entre chacune des deux sorties de chaque dispositif de couplage étant grande à la fréquence du signal incident par rapport aux impédances de charges dynamiques des premier et second transformateurs et faible à la fréquence d'oscillation locale.

2. Mélangeur en anneau selon la revendication 1, caractérisé en ce que le premier (21) et le second (23) circuit de couplage sont des selfs inductances à fort coefficient de couplage entre spires, ayant un point milieu et deux extrémités constituant respectivement l'entrée et les deux sorties du circuit de couplage considéré.

3. Mélangeur en anneau selon l'une des revendications 1 ou 2, caractérisé en ce que le dispositif générateur comporte un transformateur (26) ayant un secondaire symétrique (25) dont le point milieu est connecté à la masse et les deux extrémités sont reliées respectivement aux entrées des deux circuits de couplage (21, 23).

4. Mélangeur en anneau selon l'une des revendications 1 ou 2, caractérisé en ce que le dispositif générateur comporte un transformateur (26) ayant un secondaire symétrique (25) dont le point milieu est connecté à la masse à travers une résistance (30) découplée par un condensateur (31) et dont les deux extrémités sont reliées respectivement aux entrées des deux circuits de couplage (21, 23).

5. Mélangeur en anneau selon la revendication 4, caractérisé en ce que le dispositif générateur comporte en outre une source de tension continue (V) couplée au point milieu de l'enroulement symétrique (25) du transformateur (26) de ce dispositif.

6. Récepteur radioélectrique comportant un mélangeur en anneau selon l'une des revendications 1 à 5.

**Patentansprüche**

1. Ringmischer mit:

— einem ersten Transformator (1), der eine ein Eingangssignal empfangende Primärwicklung (2) und eine symmetrische Sekundärwicklung (4) umfaßt, deren Mittelpunkt (5) mit Masse verbunden ist und die ein erstes sowie ein zweites Ende (6, 9) aufweist;

— einem zweiten Transformator (12), der eine Sekundärwicklung (18) umfaßt, die das Ausgangssignal des Mischers abgibt, und eine symmetrische Primärwicklung (13) umfaßt, deren Mittelpunkt (14) mit Masse verbunden ist und die ein erstes und ein zweites Ende (15, 17) aufweist;

— einer ersten und einer zweiten Halbleitervorrichtung (7, 10), welche die beiden ersten Enden (6, 15) bzw. die beiden zweiten Enden (9, 17) miteinander verbinden;

— einer dritten und einer vierten Halbleitervorrichtung (8, 11), die das erste Ende (6) der symmetrischen Sekundärwicklung (4) mit dem zweiten Ende (17) der symmetrischen Primärwicklung (13) bzw. das zweite Ende (9) der symmetrischen Sekundärwicklung (4) mit dem ersten Ende (15) der symmetrischen Primärwicklung (13) verbinden;

— wobei die erste, zweite, dritte und vierte Halbleitervorrichtung jeweils die Kollektor-Emitter-Strecke eines ersten, zweiten, dritten bzw. vierten Transistors gleichen Typs sind und diese vier Transistoren so angeschlossen sind, daß jede Elektrode gleicher Art mit dem ersten oder zweiten Ende desselben Transformators verbunden ist;

— einer symmetrischen Generatorvorrichtung (26) mit zwei Ausgängen zur Erzeugung eines Lokaloszillatorsignals; dadurch gekennzeichnet, daß er ferner umfaßt: eine erste Koppelschaltung (21), die einen an einen Ausgang der Generatorvorrichtung angekoppelten Eingang (22) und zwei Ausgänge aufweist; und eine zweite Koppelschaltung (23), die einen mit dem anderen der beiden Ausgänge der Generatorvorrichtung gekoppelten Eingang (24) und zwei Ausgänge aufweist; wobei die beiden Ausgänge der ersten Koppelschaltung (21) die Basiselektroden des ersten und des zweiten Transistors gleichphasig speisen, die zwei Ausgänge der zweiten Schaltung (23) die Basiselektroden des dritten und vierten Transistors gleichphasig speisen und die Impedanz zwischen jedem der beiden Ausgänge jeder Kopplungsvorrichtung bei der Frequenz des Eingangssignals groß ist im Vergleich zu den dynamischen Lastimpedanzen des ersten und des zweiten Transformators und bei der Lokaloszillatorfrequenz gering ist.

2. Ringmischer nach Anspruch 1, dadurch gekennzeichnet, daß die erste (21) und die zweite (23) Koppelschaltung Selbstinduktionselemente mit hohem Kopplungskoeffizienten zwischen den Windungen sind, die einen Mittelpunkt und zwei Enden aufweisen, die den Eingang bzw. die beiden Ausgänge der betrachteten Koppelschaltung bilden.

3. Ringmischer nach Anspruch 1 oder 2, dadurch gekennzeichnet, daß die Generatorvorrichtung einen Transformator (26) umfaßt, der eine symmetrische Sekundärwicklung (25) aufweist, deren Mittelpunkt mit der Masse verbunden ist und deren beiden Enden jeweils mit einem Eingang der zwei Koppelschaltungen (21, 23) verbunden sind.

4. Ringmischer nach Anspruch 1 oder 2, dadurch gekennzeichnet, daß die Generatorvorrichtung einen Transformator (26) umfaßt, der eine symmetrische Sekundärwicklung (25) aufweist, deren Mittelpunkt über einen durch einen Kondensator (31) entkoppelten Widerstand (30) mit Masse verbunden ist und deren beiden Enden jeweils mit einem Eingang der beiden Koppelschaltung (21, 23) verbunden sind.

5. Ringmischer nach Anspruch 4, dadurch gekennzeichnet, daß die Generatorvorrichtung ferner eine Gleichspannungsquelle (V) umfaßt, die an den Mittelpunkt der symmetrischen Wicklung (25) des Transformators (26) dieser Vorrichtung angekoppelt ist.

6. Radioelektrischer Empfänger mit einem Ringmischer nach einem der Ansprüche 1 bis 5.

**Claims**

1. Ring mixer comprising:

— a first transformer (1) comprising a primary winding (2) receiving an input signal and a symmetrical secondary winding (4) having a center point (5) connected to ground, a first and a second end (6, 9);

— a second transformer (12) comprising a secondary winding (18) providing the output signal of the mixer and a symmetrical primary winding (13) having a center point (14) connected to ground, a first and a second end (15, 17);

— first and second semiconductor devices (7, 10) interconnecting the two first (6, 15) and the two second (9, 17) ends, respectively;

— third and fourth semiconductor devices (8, 11) interconnecting the first end (6) of the symmetrical secondary winding (4) and the second end (17) of the symmetrical primary winding (13) and the second end (9) of the symmetrical secondary winding (4) with the first end (15) of the symmetrical primary winding (13), respectively;

— the first, second, third and fourth semiconductor devices each being formed by the collector-emitter zone of first, second, third and fourth transistors of the same type, these four transistors being connected in such a manner that each electrode of the same type is connected to the first or second end of the same transformer;

— a symmetrical local oscillation generator device (26) having two outputs; characterized in that it further comprises: a first coupling circuit (21) having an input (22) coupled to one of the outputs of the generator device and two outputs; and a second coupling circuit (23) having an input (24) coupled to the other of the two outputs of the generator device and two outputs; the two outputs of the first coupling circuit (21) feeding in-phase the base electrodes of the first and second transistors, respectively, the two outputs of the second circuit (23) feeding in-phase the base electrodes of the third and fourth transistors, respectively, the impedance between each of the two outputs of each coupling device being large with respect to the dynamic load impedances of the first and second transformers at the frequency of the input signal and low at the local oscillation frequency.

2. Ring mixer in accordance with claim 1, characterized in that the first (21) and the second (23) coupling circuits are self-inductances having a high coupling coefficient between the windings and having a center point and two ends forming the input and the two outputs of the coupling circuit considered, respectively.

3. Ring mixer in accordance with claim 1 or 2, characterized in that the generator device comprises a transformer (26) having a symmetrical secondary winding (25) the center point of which is connected to ground and the two ends are connected to the inputs of the two coupling circuits (21, 23), respectively.

4. Ring mixer in accordance with claim 1 or 2, characterized in that the generator device comprises a transformer (26) having a symmetrical secondary winding (25) the center point of which is connected to ground through a resistor (30) decoupled by a capacitor (31) and the two ends of which are connected to the inputs of the two coupling circuits (21, 23), respectively.

5. Ring mixer in accordance with claim 4, characterized in that the generator device further comprises a direct voltage source (V) coupled to the center point of the symmetrical winding (25) of the transformer (26) of that device.

6. Radioelectric receiver comprising a ring mixer in accordance with any of claims 1 to 5.

# FIG_1

# FIG_2